Europäisches Patentamt

European Patent Office

Office européen des brevets

(19)

(11) Veröffentlichungsnummer: **0 150 297**
**B1**

(12) **EUROPÄISCHE PATENTSCHRIFT**

(45) Veröffentlichungstag der Patentschrift: **25.04.90**

(51) Int. Cl.⁵: **H 03 J 7/18**

(21) Anmeldenummer: **84113886.0**

(22) Anmeldetag: **16.11.84**

(54) Verfahren zur Identifikation von Rundfunksendern und Rundfunkgerät hierfür.

(30) Priorität: **20.01.84 DE 3401844**

(43) Veröffentlichungstag der Anmeldung:
**07.08.85 Patentblatt 85/32**

(45) Bekanntmachung des Hinweises auf die
Patenterteilung:
**25.04.90 Patentblatt 90/17**

(84) Benannte Vertragsstaaten:
**AT CH DE FR GB IT LI**

(56) Entgegenhaltungen:
**DE-A-3 040 465**

**FUNKSCHAU, Nr. 23, November 1981, Seiten
69-73, München, DE; H. KELLER: "FM-
Synthesizer-Tuner"**

**FUNKSCHAU, Nr. 18, 1978, Seiten 886-888,
München, DE; W. HENZE: "Mikroprozessor
steuert UKW-Empfänger"**

(73) Patentinhaber: **Blaupunkt-Werke GmbH
Robert-Bosch-Strasse 200
D-3200 Hildesheim (DE)**

(72) Erfinder: **Kässer, Jürgen, Dr. Dipl.-Phys
Ahornweg 5
D-3201 Diekholzen (DE)**
Erfinder: **Seibold, Peter, Dipl.-Ing.
Lehmkamp 33 D
D-3201 Diekholzen (DE)**
Erfinder: **Strauss, Karl-Peter, Dipl.-Ing.
Lachnerring 26
D-3200 Hildesheim (DE)**

(74) Vertreter: **Eilers, Norbert, Dipl.-Phys.
Blaupunkt-Werke GmbH Robert-Bosch-Strasse
200
D-3200 Hildesheim (DE)**

# EP 0 150 297 B1

## Beschreibung

Die Erfindung betrifft ein Verfahren zur Identifikation von mit einem Rundfunkempfänger, insbesondere Autoradio, empfangenen Rundfunksendern und eine Vorrichtung zur Durchführung des Verfahrens der im Oberbegriff des Anspruchs 1 angegebenen Gattung.

Ein solches Identifikationsverfahren, bzw. eine Vorrichtung zur Durchführung eines solchen Verfahrens, dient der Bestimmung eines per Suchlauf oder per Tastenwahl eingestellten Senders nach Sendeanstalt, Programm und Senderstandort. Der identifizierte Sender wird per Anzeige oder Sprachausgabe dem Hörenden zur Kenntnis gebracht und kann darüber hinaus zur Steuerung verschiedener Vorgänge verwendet werden. Eine solche Identifikation ist deshalb erforderlich, da die Sendefrequenzen von Sendern, die räumlich weit auseinanderliegen und sich daher nicht stören, mehrfach belegt sind und somit die Bestimmung eines Senders nur anhand der Empfangsfrequenz nicht eindeutig ist.

Aus der Zeitschrift "Funkschau" 1981, Heft 23, Seiten 69 bis 73 ist ein FM-Synthesizer-Tuner mit automatischer Sender-Identifikation bekannt, bei dem allen Senderstandorten zur Programmierung entsprechende Standortnummern zugeordnet werden. In einem Hauptspeicher sind Daten über Senderstandorte, Station, Programmnummer und Senderleistung gespeichert, die zur Senderidentifikation verwendet werden. Eine Senderidentifikation ist mit dem Tuner nur möglich, wenn zuvor der Empfängerstandort manuell eingegeben wurde. Da nach jedem Standortwechsel des Tuners der aktuelle Empfängerstandort immer neu eingegeben werden muß, ist eine Anwendung der bekannten Anordnung in mobilen Empfängern, wie Autoradios oder dergleichen, nicht praktikabel. Ferner weist eine geographische Senderverteilung in einer Datenmatrix nach Bild 3 der Literaturstelle erhebliche Unterschiede bezüglich der Entfernungen zwischen den einzelnen Senderstandorten auf.

Da die Senderstandorte zudem mit unterschiedlicher Dichte angesiedelt sind, dürfte eine entfernungsmäßig homogene Anordnung in einer derartigen Matrix ohnehin nicht machbar sein.

Bei dem aus der DE—A—30 40 465 bekannten Empfänger sind die in den einzelnen Postleitzahlbereichen empfangbaren Sender mit ihren Daten, wie Postleitzahl, Senderfrequenz, Name der Sendeanstalt und Programm der Sendeanstalt, in einem Hauptspeicher fest gespeichert. Für jeden Postleitzahlbereich muß somit ein Frequenzmuster der möglicherweise empfangbaren Sender abgespeichert sein, wobei die Postleitzahlen als solche keine Beziehungen zueinander haben. Bei der Inbetriebnahme des Empfängers werden mittels Sendersuchlauf nacheinander die Frequenzen aller empfangbaren Sender ermittelt und in einem Arbeitsspeicher abgelegt. Daraufhin wird das im Arbeitsspeicher abgelegte Frequenzmuster mit den Frequenzmustern aller Postleitzahlbereiche verglichen und so der Postleitzahlbereich mit der größten Übereinstimmung ermittelt. Aus der zugeordneten Postleitzahl soll dann auf den zu identifizierenden Sender geschlossen werden. Eine direkte Identifizierung des Senderstandortes (Antennenstandort) findet hierbei nicht statt, es findet lediglich eine Zuordnung des empfangbaren Senderspektrums zu einer Ordnungszahl statt.

Ein aus der DE—A—28 50 733 bekannter Rundfunkempfänger verwendet die von Verkehrsfunksendern (VF-Sendern) abgestrahlte Bereichserkennung zur Identifizierung von Sendern, auch solchen Sendern, die selbst keine VF-Sender sind, aber Sendeanstalten zugeordnet werden können, die VF-Sender besitzen. Damit ist naturgemäß die Identifikation auf solche Sender beschränkt, die im Empfangsbereich von VF-Sendern sind oder zu Sendeanstalten mit VF-Sendern gehören. Eine Senderidentifikation ist damit nur im Empfangsbereich von VF-Sendern möglich.

Der Erfindung liegt die Aufgabe zugrunde, ein Verfahren der eingangs genannten Art sowie ein Rundfunkgerät zur Durchführung des Verfahrens zu schaffen, mit dem ohne Einschränkung die Bestimmung aller in einem vorgegebenen Bereich empfangbaren Sender einwandfrei und zuverlässig durchgeführt werden kann.

Die Aufgabe ist bei einem Identifikationsverfahren sowie bei einem Rundfunkgerät zur Durchführung des Identifikationsverfahrens der im Oberbegriff des Anspruchs 1 bzw. 7 angegebenen Gattung erfindungsgemäß durch die Merkmale im Kennzeichenteil des Anspruchs 1 bzw. 7 gelöst.

Mit dem erfindungsgemäßen Verfahren können alle in einem vorgegebenen Bewegungsbereich eines Autoradios empfangbaren Sender einwandfrei und automatisch identifiziert werden. Der Bewegungsbereich ist dabei nicht auf ein Land, z.B. die Bundesrepublik Deutschland, begrenzt, sondern kann beliebig groß gemacht weden. Hierzu ist es lediglich erforderlich, Informationen über Sendefrequenz, Senderstandort und Senderreichweite aller in einem vorgegebenen Bereich empfangbaren Sender abzuspeichern.

Der zur Identifikation des empfangenen Rundfunksenders erforderliche Vergleichssender kann entweder per Suchlauf gefunden werden, oder aber gemäß den Merkmalen des Anspruchs 2 durch Vorgabe der einzustellenden Sendefrequenz eines Senders mit einem Senderstandort, dessen Reichweitenüberschuß bezüglich eines der ausgesuchten Senderstandorte groß, vorzugsweise maximal ist und/oder mit der geringsten Zahl von ausgesuchten Senderstandorten einen Reichweitenüberschuß erzielt. Unter Reichweitenüberschuß, der dem Überlappungsgrad der Empfangsgebiete zweier Senderstandorte entspricht, wird die Differenz aus der Summe der Senderreichweiten der Senderstandorte und ihrer Entfernung verstanden.

Zur Erzielung einer möglichst kurzen Abprüfzeit beim Auffinden der einzustellenden Sendefrequenz ist

2

es vorteilhaft, gemäß den Merkmalen des Anspruchs 3 denjenigen der ausgesuchten Senderstandorte heranzuziehen, dem der zuletzt empfangene und identifizierte Sender zugehörig ist. Damit ist eine sehr große Wahrscheinlichkeit gegeben, daß der einzustellende Vergleichssender, dessen Überlappungsgrad im Empfangsgebiet mit dem herangezogenen Sender groß ist, auch an dem momentanen Standort des Rundfunkempfängers empfangen wird.

Eine vorteilhafte Ausführungsform eines Rundfunkgeräts zur Durchführung des erfindungsgemäßen Verfahrens ergibt sich aus Anspruch 7, insbesondere in Verbindung mit einen oder mehrere der weiteren Ansprüche 8—10. Dabei sind zweckmäßigerweise die Baugruppen Steuerlogik, Recheneinheit und Vergleichseinheit in einen Mikroprozessor integriert.

Die Erfindung ist anhand eines in der Zeichnung dargestellten Ausführungsbeispiels eines Rundfunkgeräts zum Durchführen des erfindungsgemäßen Senderidentifikationsverfahrens im folgenden näher beschrieben. Es zeigen:

Fig. 1 ein Blockschaltbild eines Rundfunkgeräts,

Fig. 2 eine Auflistung eines momentanen Speicherinhalts eines Zwischenspeichers des Rundfunkgeräts in Fig. 1 für ein ausgewähltes Beispiel,

Fig. 3 ein Diagramm der Empfangsfeldstärke in Abhängigkeit von der Entfernung zum Senderstandort mit der Senderreichweite als Parameter.

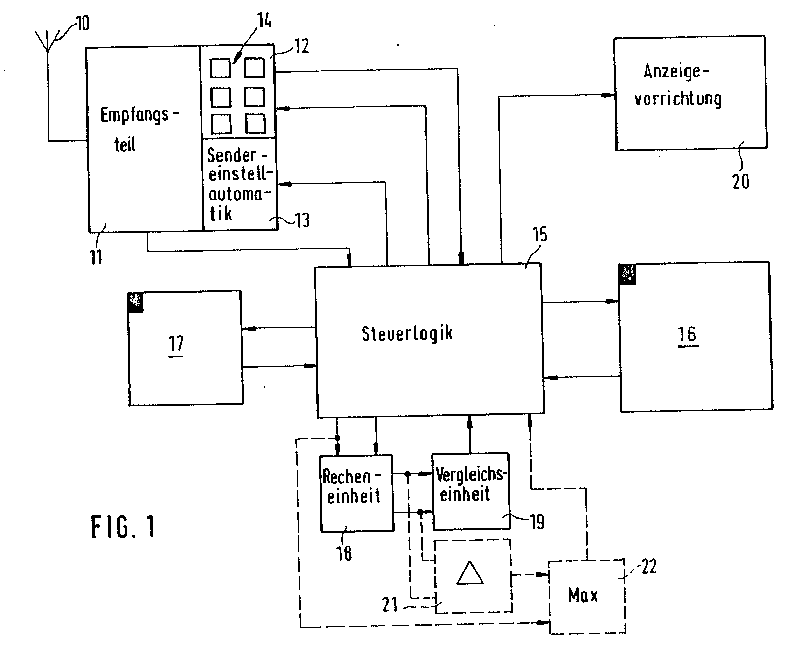

Das in Fig. 1 schematisch angedeutete Rundfunkgerät weist einen mit einer Antenne 10 verbundenen Empfangsteil 11 mit einer Sendervorwahleinrichtung 12 und einer Sendereinstellautomatik 13 auf. Mit der Sendereinstellautomatik kann je nach Vorwahl im Tastenfeld 14 der Sendervorwahleinrichtung Sendersuchlauf durchgeführt werden oder ein mittels des Tastenfeldes 14 angewählter Sender eingestellt werden. Sendervorwahleinrichtung 12 und Sendereinstellautomatik 13 werden von einer Steuerlogik 15 gesteuert, die noch mehrere Steuerfunktionen ausführt und im allgemeinen von einem Mikroprozessor gebildet wird.

Das Rundfunkgerät weist ferner einen als Lesespeicher ausgebildeten Hauptspeicher 16 auf, in welchem alle im möglichen Aktionsradius des Rundfunkgeräts empfangbaren Sender mit ihren Sendefrequenzen, Senderstandorten, abgestrahlten Programmen und Senderreichweiten abgespeichert sind. Die Senderstandorte sind dabei durch Standortkoordinaten gekennzeichnet, die entweder in Längen- und Breitengraden angegeben sind oder nach einem speziellen Koordinatensystem festgelegt sind. Im Rundfunkgerät ist außerdem noch ein als Schreib-Lese-Speicher ausgebildeter Zwischenspeicher 17 vorgesehen, in welchem vorübergehend ausgewählte Informationen aus dem Hauptspeicher 16 zwischengespeichert werden können.

Eine Recheneinheit 18 und eine Vergleichseinheit 19, die zusammen mit der Steuerlogik 15 Teil des Mikroprozessors sind, vervollständigen zusammen mit einer Anzeigevorrichtung 20 das Rundfunkgerät. Die Recheneinheit 18 ist derart ausgebildet, daß sie aus Standortkoordinaten zweier Senderstandorte deren Entfernung voneinander berechnet und andererseits die Senderreichweiten zweier jeweils einem dieser Standorte zugehörigen Sender addiert. Die Vergleichseinheit 19 ist derart ausgebildet, daß sie dann ein Ausgangssignal abgibt, wenn die Summe der Senderreichweiten größer ist als die Entfernung der zugehörigen Standorte voneinander. In einem weiteren Ausführungsbeispiel werden die von der Recheneinheit 18 getrennt ausgegebenen Rechenergebnisse noch einer in der Zeichnung strichliniert dargestellten Substrahierstufe 21 zugeführt, dessen Ausgang mit einem ebenfalls strichliniert dargestellten Maximumsucher 22 verbunden ist, der noch zusätzlich jeweils den aus dem Hauptspeicher 16 ausgelesenen Senderstandort zugeführt erhält. Die Subtrahierstufe bildet aus den beiden Ergebnissen der Recheneinheit 18 die Differenz, die ein Maß für den Reichweitenüberschuß zweier zu vergleichender Senderstandorte ist. Der Reichweitenüberschuß, der identisch mit dem Überlappungsmaß oder Überlappungsgrad der Empfangsgebiete zweier zu vergleichender Senderstandorte ist, ist somit die Summe der Senderreichweiten zweier Senderstandorte, verringert um deren Entfernung voneinander. Der Maximumsucher 22 bestimmt aus den zugeführten Senderstandorten denjenigen, dem die größte Differenz zugehörig ist.

Mit dem in dieser Weise aufgebauten Rundfunkgerät wird das Senderidentifikationsverfahren wie folgt durchgeführt, wobei zunächst anhand eines Beispiels dasjenige Verfahren beschrieben wird, bei welchem der oder die zur Identifikation des empfangenen Senders erforderlichen Vergleichssender per Suchlauf bestimmt wird bzw. werden.

Für das Beispiel wird angenommen, daß sich ein Kraftfahrzeug mit einem solchen, als Autoradio ausgebildeten Rundfunkgerät auf der Autobahn zwischen Walsrode und Hannover befindet. Im Autoradio wird ein Sender mit Empfangsfrequenz $f_e = 91,8$ MHz empfangen.

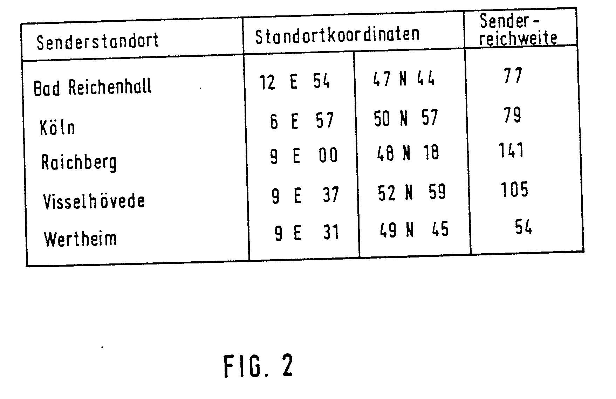

Die im Empfangsteil 11 gemessene Empfangsfrequenz $f_e$ wird der Steuerlogik 15 zugeführt. Aus dem Hauptspeicher 16 werden nun alle diejenigen Standorte von Sendern ausgesucht, deren Sendefrequenz mit der Empfangsfrequenz $f_e$ übereinstimmen. Die Senderstandorte mit Standortkoordinaten und die Senderreichweiten dieser Sender werden aus dem Hauptspeicher 16 ausgelesen und in dem Zwischenspeicher 17 abgelegt. Im Zwischenspeicher 17 befinden sich nunmehr diejenigen Informationen, wie sie in Fig. 2 angegeben sind. Die Koordinaten des Senderstandortes sind hier in Längen- und Breitengraden angegeben.

Nunmehr wird von der Steuerlogik 15 die Sendereinstellautomatik 13 angesteuert und ein Suchlauf ausgelöst. Dieser Suchlauf stellt als nächsten empfangbaren Sender einen Sender mit der Sendefrequenz

EP 0 150 297 B1

$f_s$=93,1 MHz ein. Diese im Empfangsteil 11 gemessene Frequenz wird wiederum der Steuerlogik 15 zugeführt. Im Hauptspeicher 16 werden nunmehr nacheinander alle Senderstandorte aufgesucht, die einen Sender mit der Sendefrequenz $f_s$ tragen. Diese Senderstandorte werden nacheinander jeweils mit den im Zwischenspeicher 17 abgelegten Senderstandorten verglichen und jeweils geprüft, ob sich die Empfangsgebiete der Sender überlappen. Eine Überlappung der Empfangsgebiete liegt dann vor, wenn die Summe der Senderreichweiten der beiden zu vergleichenden Senderstandorte größer ist als die Entfernung der Senderstandorte voneinander.

Im Beispiel würde aus dem Hauptspeicher 16 zunächst der Senderstandort Bad Marienberg mit den Standortkoordinaten 7 E 58, 50 N 40 und der Senderreichweite 130 km ausgelesen werden. Dieser Senderstandort wird bezüglich der Empfangsgebiete mit allen im Zwischenspeicher 17 abgelegten Senderstandorten (Fig. 2) verglichen. Eine Überlappung der Empfangsgebiete ergibt sich dabei nur für den Senderstandort Köln, da die Entfernung Bad Marienberg/Köln (ca. 80 km) kleiner ist als die Summe der Senderreichweiten Bad Marienberg 130 km und Köln 79 km, also 209 km. Der Senderstandort Köln im Zwischenspeicher 17 wird markiert.

Der nächste Senderstandort mit Sendefrequenz $F_s$=93,1 MHz ist Hamburg mit den Standortkoordinaten 10 E 6, 53 N 31 und der Senderreichweite 166 km. Der sukzessive Vergleich mit allen Senderstandorten im Zwischenspeicher 17 bezüglich der Überlappung der Empfangsgebiete ergibt nur eine Überlappung des Senderstandortes Hamburg mit dem Senderstandort Visselhövede. Im Zwischenspeicher 17 wird Visselhövede markiert. Weitere Senderstandorte mit Sendern der Sendefrequenz $F_s$=93,1 MHz sind Hühnerberg, Kreuzberg und Lübeck. Eine gleichermaßen durchgeführte Prüfung der Empfangsgebiete ergibt keinerlei Überlappung mit den im Zwischenspeicher 17 abgelegten Senderstandorten, da hier immer die Summe der jeweiligen Senderreichweiten kleiner ist als die Entfernung der Senderstandorte. In dem Zwischenspeicher 17 werden nunmehr alle die Senderstandorte eliminiert, also gelöscht, die nicht markiert worden sind, da keine Überlappung der Empfangsgebiete aufgetreten ist. Im Zwischenspeicher 17 verbleiben also noch die Senderstandorte Köln und Visselhövede. Nunmehr wird von der Steuerlogik 15 der Sendersuchlauf erneut gestartet und der nächste empfangbare Sender eingestellt, der im Beispiel die Sendefrequenz $f_s$=93,8 MHz hat. Diese Sendefrequenz wird wiederum der Steuerlogik 15 zugeführt, und aus dem Hauptspeicher 16 werden alle diejenigen Senderstandorte mit Standortkoordinaten und Senderreichweiten sukzessive ausgelesen, die Sender mit dieser Sendefrequenz tragen. In gleicher Weise wie beschrieben, werden diese Senderstandorte mit den im Zwischenspeicher 17 verbliebenen Senderstandorten auf Überlappung ihrer Empfangsgebiete verglichen. Im Beispiel ist dies zunächst der Senderstandort Bremen mit den Standortkoordinaten 8 E 53, 53 N 7 und der Senderreichweite 178 km. Ein Überlappungsvergleich des Senderstandortes Bremen mit den im Zwischenspeicher verbliebenen Senderstandorten Köln und Visselhövede ergibt eine Überlappung mit Visselhövede, da die Entfernung Bremen/Visselhövede wesentlich kleiner als die Summe der Reichweiten 178 und 105=283 km ist.

Weitere Senderstandorte mit einem Sender der Sendefrequenz $f_s$=93,8 MHz sind Feldberg, Saarburg und Waldenburg. In gleicher Weise werden diese Senderstandorte mit Standortkoordinaten und Senderreichweiten aus dem Hauptspeicher 16 ausgelesen und jeweils mit den Senderstandorten Köln und Visselhövede im Zwischenspeicher 17 auf Überlappung geprüft. Eine weitere Überlappung von Empfangsgebieten tritt jedoch nicht auf. Der nicht markierte Senderstandort Köln wird nunmehr wiederum gestrichen und es verbleibt im Zwischenspeicher 17 der einzige Senderstandort Visselhövede. Der mit der Empfangsfrequenz $f_e$=91,8 MHz empfangene und hörbar gemachte Sender weist damit den Senderstandort Visselhövede auf. Aus dem Hauptspeicher 16 kann mit dem Senderstandort Visselhövede und der Empfangsfrequenz $f_e$=91,8 MHz der Sender als NDR 1 identifiziert werden. Der identifizierte Sender wird mit Senderstandort "Visselhövede", Sendeanstalt "NDR" und Programm "1" in der Anzeige 20 sichtbar gemacht.

Im Falle, daß auch beim Abprüfen des zweiten Vergleichssenders mehr als ein einziger Senderstandort im Zwischenspeicher 17 verbleibt, für die Überlappung der Empfangsgebiete mit dem Vergleichssender festgestellt worden ist, so wird per Suchlauf ein weiterer Vergleichssender aufgesucht, und der beschriebene Vorgang wiederholt sich solange, bis nur ein einziger Senderstandort im Zwischenspeicher 17 verbleibt, der dann der Senderstandort des identifizierten Senders ist.

Da für den Sendersuchlauf üblicherweise eine relativ lange Suchzeit erforderlich ist, kann das Senderidentifikationsverfahren noch nach einer weiteren Verfahrensvariante durchgeführt werden, bei welcher der oder die Vergleichssender vorgegeben werden und deren Sendefrequenzen von der Sendereinstellautomatik 13 unmittelbar eingestellt werden. Das Verfahren arbeitet schneller, da die Zeit zum Einstellen der vorgegebenen Sender wesentlich kürzer ist als die für einen Suchlauf benötigte Zeit. Dieser Verfahrensvariante wird wiederum anhand des gleichen Beispiels erläutert:

Die im Empfangsteil 11 des Rundfunkgeräts ermittelte Empfangsfrequenz $f_e$=91,8 MHz wird wiederum der Steuerlogik 15 zugeführt. Diese liest in gleicher Wiese aus dem Hauptspeicher 16 sämtliche Senderstandorte mit Standortkoordinaten und Senderreichweiten aus, denen Sender mit der Sendefrequenz 91,8 MHz zugehörig sind. Diese Daten werden in gleicher Weise in dem Zwischenspeicher 17 abgelegt, so daß der in Fig. 2 darstellte Informationsinhalt des Zwischenspeichers 17 auch hierfür zutrifft. Von den aus dem hauptspeicher 16 ausgelesenen und in dem Zwischenspeicher 17 abgelegten Senderstandorten wird ein Senderstandort ausgewählt. Bevorzugt wird derjenige Senderstandort

4

ausgewählt, der einen Sender trägt, der im Rundfunkgerät zuletzt empfangen und hörbar gemacht worden ist; denn da sich die Position des Rundfunkempfängers nicht so schnell ändert, kann man davon ausgehen, daß ein Sender von einem solchen Senderstandort am momentanen Ort des Rundfunkempfängers empfangen werden kann. Steht ein solcher zuletzt empfangener Sender nicht zur Verfügung, so kann ein beliebiger der Senderstandorte ausgewählt werden, wobei möglicherweise aber alle Senderstandorte abgearbeitet werden müssen, bevor ein nach den nachstehenden Verfahrensschritten ermittelter empfangbarer Vergleichssender gefunden worden ist. In dem hier beschriebenen Beispiel ist der ausgewählte Senderstandort im Zwischenspeicher 17 der Senderstandorte Visselhövede.

Aus dem Hauptspeicher 16 werden nacheinander alle Senderstandorte mit Standortkoordinaten und Senderreichweiten ausgelesen. Jeweils ein ausgelesener Senderstandort wird mit dem ausgewählten Senderstandort "Visselhövede" auf Überlappung der Empfangsgebiete geprüft. Hierzu wird die Differenz aus der Summe der beiden Senderreichweiten und der Entfernung ihrer Senderstandorte gebildet, was in der Recheneinheit 18 und in der Subtrahierstufe 21 durchgeführt wird. Als Vergleichssender wird ein Sender von einem solchen Senderstandort ausgewählt, bei dem die Differenz, die ein Maß für die Überlappung oder Überschneidung der Empfangsgebiete ist, ein Maximum ist. Hierzu wäre der ebenfalls in dem Mikroprozessor integrierte Maximumsucher 22 geeignet, der aber auch als einfacher Komparator mit entsprechender Schwelle ausgebildet sein kann und den ersten Sender bestimmt, bei dem die Differenz, also der Reichweitenüberschuß, die Schwelle übersteigt. Kommen mehrere Senderstandorte in Betracht, bei denen der Reichweitenüberschuß die Schwelle übersteigt, so wird derjenige ausgewählt, dessen Empfangsgebiet mit der geringsten Zahl der Empfangsgebiete der im Zwischenspeicher 17 abgekehrten Senderstandorte eine Überlappung zeigt. Im Beispiel wird Senderstandort Visselhövede gefunden. Es ist vorteilhaft dem Kriterium der geringen Mehrdeutigkeit, d.h. der geringsten Zahl der Empfangsüberlappung, den Vorrang vor dem maximalen Reichweitenüberschuß einzuräumen.

Es wird nun ein Sender des Senderstandortes Visselhövede ausgewählt, hier BFBS mit Sendefrequenz $f_s$=97,6 MHz, und über die Sendereinstellautomatik 13 im Empfangsteil 11 eingestellt. Der Sender kann am Standort des Rundfunkgeräts empfangen werden. Damit werden aus dem Hauptpsiecher 16 sukzessive alle Senderstandorte mit Standortkoordinaten und Senderreichweiten ausgelesen, die einen Sender mit der Sendefrequenz $f_s$=97,6 MHz aufweisen. Im Ausführungsbeispiel sind dies die Senderstandorte Visselhövede, Gelbelsee, Würzburg und Brandenkopf. Jeder im Zwischenspeicher 17 abgespeicherte Senderstandort wird nunmehr mit diesen Senderstandorten auf Überlappung geprüft, wobei jeweils geprüft wird, ob die Summe der Senderreichweiten größer ist als die Entfernung der Senderstandorte voneinander. Die hierfür berechneten Daten sind nachfolgend aufgelistet:

| Senderstandort im Speicher 17 | Reich-weite (km) | Senderstandort aus Speicher 16 | Reich-weite (km) | Entfernung (km) | Über-lappung |
|---|---|---|---|---|---|
| Bad Reichenhall | 77 | Visselhövede | 125 | 679,4 | nein |
| " | 77 | Gelbelsee | 122 | 210,1 | nein |
| " | 77 | Würzburg | 111 | 401,7 | nein |
| " | 77 | Brandenkopf | 101 | 532,5 | nein |
| Visselhövede | 105 | Visselhövede | 125 | 0 | ja |
| " | 105 | Gelbelsee | 122 | 485,3 | nein |
| " | 105 | Würzburg | 111 | 352,3 | nein |
| " | 105 | Brandenkopf | 101 | 536,6 | nein |
| Wertheim | 54 | Visselhövede | 125 | 354,9 | nein |
| " | 54 | Gelbelsee | 122 | 230,5 | nein |
| " | 54 | Würzburg | 111 | 42,8 | ja |
| " | 54 | Brandenkopf | 101 | 217,7 | nein |
| Raichberg | 141 | Visselhövede | 125 | 518,8 | nein |
| " | 141 | Gelbelsee | 122 | 279,9 | nein |
| " | 141 | Würzburg | 111 | 191,1 | ja |
| " | 141 | Brandenkopf | 101 | 94,6 | ja |
| Köln | 79 | Visselhövede | 125 | 371,7 | nein |
| " | 79 | Gelbelsee | 122 | 545 | nein |
| " | 79 | Würzburg | 111 | 352,4 | nein |
| " | 79 | Brandenkopf | 101 | 318 | nein |

Die Senderstandorte im Zwischenspeicher 17, die keine Überlappung zeigen, werden wiederum im Zwischenspeicher 17 gelöscht. Es verbleiben die Senderstandorte Visselhövede, Wertheim und Raichberg.

Als nächstes wird die Sendefrequenz $f_s$=95,9 MHz ausgewählt, ein Sender dessen Senderstandort ebenfalls Visselhövede ist. In gleicher Weise werden aus dem Hauptspeicher 16 alle Senderstandorte ausgelesen, und zwar mit Standortkoordinaten und Senderreichweiten, die einen Sender mit der Sendefrequenz $f_s$=95,9 MHz aufweisen. Dies sind die Sender Hochberg, Inntal, Visselhövede, Weinbit und Aachen. Eine Berechnung der Überlappungsgebiete ergibt wiederum, daß für jeden dieser im Zwischenspeicher 17 verbliebenen Senderstandorte Visselhövede, Wertheim und Raichberg Überlappungen mit einem der Empfangsgebiete der vorstehend genannten aus dem Hauptspeicher 16 ausgelesenen Senderstandorte besteht. Es wird kein Senderstandort im Zwischenspeicher 17 gelöscht.

Als nächstes wird die Sendefrequenz $f_s$=98,4 MHz, ebenfalls ein Sender des eingangs aus dem Hauptspeicher 16 mit dem Reichweitenüberschußmaximum-Kriterium ausgelesenen Senderstandorts Visselhövede, ausgewählt.

Wiederum werden aus dem Hauptspeicher 16 alle Senderstandorte mit Standortkoordinaten und Senderreichweiten ausgelesen, die einen Sender der Sendefrequenz $f_s$=98,4 MHz aufweisen. Dies sind Visselhövede und Hornisgrind. Das Abarbeiten des Überlappungskriterium ergibt Überlappungen für alle im Zwischenspeicher verbliebenen Senderstandorte Visselhövede, Wertheim und Raichberg.

Nun wird in gleicher Weise wie eingangs beschrieben ein neuer Senderstandort aus dem Hauptspeicher 16 aufgesucht, der gegenüber dem in Zwischenspeicher 17 ausgewählten Senderstandort Visselhövede den nächstgrößten Reichweitenüberschuß aufweist. Dies ist der Senderstandort Hamburg. Eine Sendefrequenz des Senderstandortes Hamburg, hier z.B. $f_s$=87,6 MHz, wird ausgelesen. Wiederum werden im Hauptspeicher 16 alle Senderstandorte aufgerufen, und mit Standortkoordinaten und Senderreichweiten ausgelesen, die einen Sender mit der Sendefrequenz $f_s$=87,6 MHz aufweisen. Dies sind die Senderstandorte Lindau, Dillberg, Biedenkopf und Hamburg. Die Durchführung der vorstehend mehrfach beschriebenen Überlappungsprüfung der Empfangsgebiete der aus dem Hauptspeicher 16 ausgelesenen Senderstandorten mit jedem der in dem Zwischenspeicher 17 verbliebenen Senderstandorte ergibt Überlappung für alle der Senderstandorte im Zwischenspeicher 17.

Als nächstes wird die Sendefrequenz $f_s$=90,3 MHz, ebenfalls eines Senders des Senderstandortes Hamburg, ausgewählt. Damit wiederholt sich der Vorgang des Auslesens aller Senderstandorte aus dem Hauptspeicher 16, die einen Sender mit nunmehr der Sendefrequenz $f_s$=90,3 MHz aufweisen. Dies sind die Senderstandorte Hamburg und Nordhelle. Die Überlappungsprüfung dieser beiden Senderstandorte mit den einzelnen Senderstandorten im Zwischenspeicher 17 ergibt lediglich eine Überlappung mit dem Senderstandort Visselhövede. Da sich die Zahl der Überlappungen verringert, wird die Sendefrequenz $f_s$=90,3 MHz mittels der Sendereinstellautomatik 13 eingestellt und auf Empfang geprüft. Dies ist der Fall. Im Zwischenspeicher 17 werden nun die Senderstandorte Wertheim und Raichberg gestrichen. Als einziger Senderstandort verbleibt im Zwischenspeicher 17 Visselhövede, welches der Standort des zu identifizierenden Senders ist. Mit der Empfangsfrequenz $f_e$=91,8 MHz und dem gefundenen Senderstandort Visselhövede wird nunmehr mittels des Hauptspeichers 16 der empfangene Sender als NDR 1 identifiziert. In der Anzeigevorrichtung 20 wird dem Hörenden der empfangene Sender NDR 1 und der Senderstandort Visselhövede optisch oder akustisch mittels Sprachausgabe angezeigt.

Eine Verkürzung des vorstehend beschriebenen Verfahrens durch gezieltere Auswahl der Vergleichsfrequenzen ist dann möglich, wenn die Empfangsfeldstärke des zu identifizierenden Senders und des erforderlichen Vergleichssenders bzw. der erforderlichen Vergleichssender gemessen wird und aufgrund dieser Feldstärkenmessung auf die Entfernung zum Senderstandort rückgeschlossen wird.

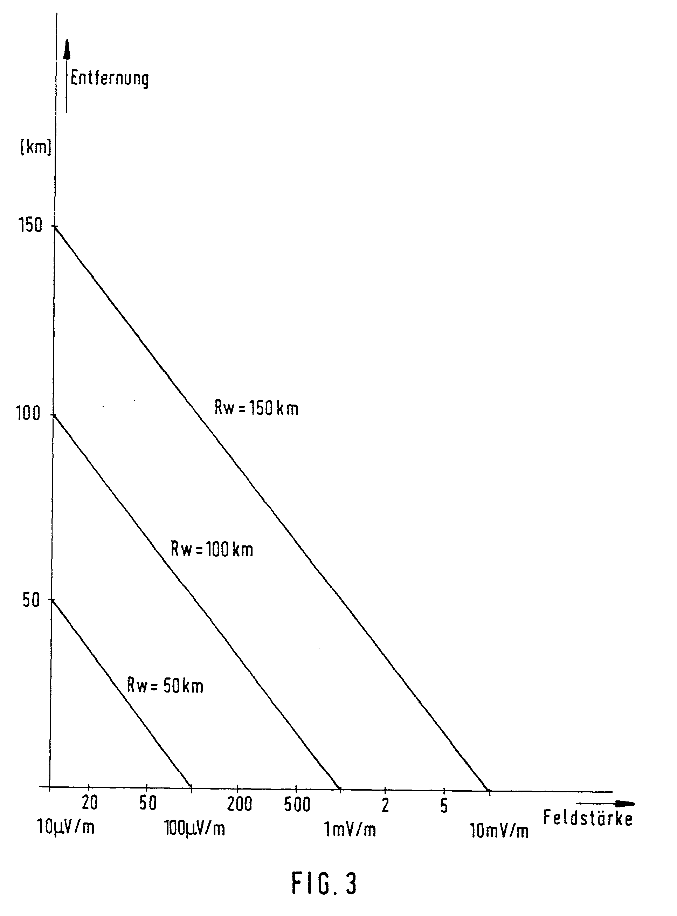

In Fig. 3 ist ein Diagramm zu sehen, daß die Abhängigkeit der Feldstärke von der Entfernung zum Senderstandort zeigt, bei verschiedenen Senderreichweiten. Die Feldstärke am Empfangsort ist im logarithmischen Maßstab aufgetragen. Wie leicht zu erkennen ist, beträgt die Empfangsfeldstärke an der Grenze des Empfangsgebiets des jeweiligen Senders, also an der maximalen Senderreichweite etwa 10 μV/m und nimmt zum Senderstandort entsprechend der Senderleistung des jeweiligen Senders exponentiell zu.

Im Beispiel des zu identifizierende Senders mit der Empfangsfrequenz $f_e$=91,8 MHz wird z.B. eine Empfangsfeldstärke von 100 μV/m gemessen. Mit dieser Empfangsfeldstärke wird nunmehr für die ausgesuchten Senderstandorte eine reduzierte fiktive Senderreichweite bestimmt, die der theoretischen Entfernung des Empfangsorts vom Senderstandort entspricht. Die ausgesuchten und im Zwischenspeicher 17 abgelegten Senderstandorte sind Bad Reichenhall, Visselhövede, Wertheim, Raichberg und Köln. Die Senderreichweiten der Sender dieser Senderstandorte sind in der Auflistung auf Seite 13 angegeben. Mit diesen Senderreichweiten und der Empfangsfeldstärke von 100 μV/m werden nunmehr aus dem Diagramm in Fig. 3 die fiktiven Senderreichweiten der Senderstandorte, also die mögliche theoretische Entfernung des Empfangsorts von diesen Senderstandorten, bestimmt. Es ergibt sich für Bad Reichenhall eine fiktive Senderreichweite von 25 km, für Visselhövede 55 km, für Wertheim 8 km, für Raichberg 91 km und für Köln 30 km.

Im Beispiel ist als Vergleichssender der Sender BFBS mit der Sendefrequenz $f_s$=97,6 MHz eingestellt. Aus dem Hauptspeicher 16 werden wie beschrieben alle Senderstandorte mit Standortkoordinaten und Senderreichweiten ausgelesen, die einen Sender mit Sendefrequenz $f_s$=97,6 MHz aufweisen. Dies sind die Senderstandorte Visselhövede, Gelbelsee, Würzburg und Brandenkopf. Die Senderreichweiten dieser Senderstandorte sind in der Auflistung auf Seite 13 ebenfalls angegeben. Der Sender mit der Sendefrequenz $f_s$=97,6 MHz wird beispielsweise mit einer Empfangsfeldstärke von 500 μV/m empfangen. Mit dieser Empfangsfeldstärke und den Senderstandorten zugeordneten Senderreichweiten werden aus dem Diagramm in Fig. 3 wiederum die fiktiven Senderreichweiten bestimmt. Diese betragen für Visselhövede 39 km, für Gelbelsee 37 km, für Würzburg 26 km und für Brandenkopf 16 km. Die fiktiven Senderreichweiten der im Zwischenspeicher abgespeicherten Senderstandorte des Vergleichssenders und der mit diesem frequenzgleichen Sender ergeben verkleinerte fiktive Empfangsgebiete für die einzelnen Senderstandorte.

Jeder im Zwischenspeicher 17 abgespeicherte Senderstandort wird nunmehr mit den Senderstandorten Visselhövede, Gelbelsee, Würzburg und Brandenkopf auf Überlappung geprüft, wobei jeweils geprüft wird, ob die Summe der fiktiven Senderreichweiten größer ist als die Entfernung der Senderstandorte voneinander. Die hierfür berechneten Daten sind nachfolgend aufgelistet:

| Senderstandort im Speicher 17 | fikt. Reich-weite (km) | Senderstandort aus Speicher 16 | fikt. Reich-weite (km) | Entfernung (km) | Über-lappung |
|---|---|---|---|---|---|
| Bad Reichenhall | 25 | Visselhövede | 39 | 679,4 | nein |
| " | 25 | Gelbelsee | 37 | 210,1 | nein |
| " | 25 | Würzburg | 26 | 401,7 | nein |
| " | 25 | Brandenkopf | 16 | 532,5 | nein |
| Visselhövede | 55 | Visselhövede | 39 | 0 | ja |
| " | 55 | Gelbelsee | 37 | 485,3 | nein |
| " | 55 | Würzburg | 26 | 352,3 | nein |
| " | 55 | Brandenkopf | 16 | 536,6 | nein |
| Wertheim | 8 | Visselhövede | 39 | 354,9 | nein |
| " | 8 | Gelbelsee | 37 | 230,5 | nein |
| " | 8 | Würzburg | 26 | 42,8 | nein |
| " | 8 | Brandenkopf | 16 | 217,7 | nein |
| Raichberg | 91 | Visselhövede | 39 | 518,8 | nein |
| " | 91 | Gelbelsee | 37 | 279,9 | nein |
| " | 91 | Würzburg | 26 | 191,1 | nein |
| " | 91 | Brandenkopf | 16 | 94,6 | ja |
| Köln | 30 | Visselhövede | 39 | 371,7 | nein |
| " | 30 | Gelbelsee | 37 | 545 | nein |
| " | 30 | Würzburg | 26 | 352,4 | nein |
| " | 30 | Brandenkopf | 16 | 318 | nein |

Es ergibt sich lediglich eine Überlappung mit dem Empfangsgebiet der im Zwischenspeicher 17 abgespeicherten Senderstandorte Visselhövede und Raichberg. Die übrigen Senderstandorte werden gelöscht. Es zeigt sich bereits hier, daß gegenüber dem vorstehend beschriebenen Ausführungsbeispiel die Mehrdeutigkeit um einen Senderstandort verringert ist.

Wie im vorstehend beschriebenen Ausführungsbeispiel wird ein weiterer Vergleichssender aus dem Hauptspeicher 16 aufgesucht, hier dem vorstehend beschriebenen Ausführungsbeispiel folgend der Senderstandort Hamburg. Eine Sendefrequenz des Senderstandortes Hamburg, hier $f_s = 87,6$ MHz, wird ausgelesen. Diese Frequenz wird eingestellt. Die Empfangsfeldstärke des empfangenen Senders beträgt z.B. 200 µV/m. Im Hauptspeicher 16 werden alle Senderstandorte aufgerufen und mit Standortkoordinaten und Senderreichweiten ausgelesen, die einen Sender mit der Sendefrequenz $f_s = 87,6$ MHz aufweisen. Dies sind die Senderstandorte Lindau, Dillberg, Biedenkopf und Hamburg mit den Senderreichweiten 57 km, 135 km, 154 km und 137 km. Mit der Empfangsfeldstärke 200 µV/m und diesen Senderreichweiten werden die fiktiven Senderreichweiten dieser Senderstandorte bestimmt. Diese ist für Lindau irrelevant, für Dillberg 73 km, für Biedenkopf 94 km und für Hamburg 76 km. Die im Zwischenspeicher 17 verbliebenen Senderstandorte Visselhövede und Raichberg werden nunmehr mit diesen Senderstandorten auf Überlappung geprüft, wobei wiederum jeweils geprüft wird, ob die Summe der fiktiven Senderreichweiten größer ist als die Entfernung der Senderstandorte. Die hierfür sich ergebenden Daten sind nachfolgend aufgelistet:

| Senderstandort im Speicher 17 | reduz. Reich- weite (km) | Senderstandort aus Speicher 16 | reduz. Reich- weite (km) | Entfernung (km) | Über- lappung |
|---|---|---|---|---|---|
| Visselhövede | 55 | Lindau | — | 594,2 | nein |
| " | 55 | Dillberg | 73 | 445 | nein |
| " | 55 | Biedenkopf | 94 | 253,8 | nein |
| " | 55 | Hamburg | 76 | 80,8 | ja |
| Raichberg | 91 | Lindau | — | 110,7 | nein |
| " | 91 | Dillberg | 73 | 288,3 | nein |
| " | 91 | Biedenkopf | 94 | 296 | nein |
| " | 91 | Hamburg | 76 | 587,1 | nein |

Bereits diese zweite Überlappungsprüfung ergibt Eindeutigkeit, denn es verbleibt lediglich Visselhövede, dessen fiktives Empfangsgebiet sich mit dem fiktiven Empfangsgebiet des Senderstandortes Hamburg überlappt. Visselhövede ist damit als Standort des zu identifizerenden Senders bestimmt. Mit der Empfangsfrequenz $f_e$=91,8 MHz wird anhand des Standortes Visselhövede der empfangene Sender als NDR 1 identifiziert.

Die vorstehend beschriebene Heranziehung der gemessenen Empfangsfeldstärke zur schnellen Eliminierung von Mehrdeutigkeiten, d.h. zur schnellen Verringerung der im Zwischenspeicher 17 abgespeicherten Senderstandorte durch Eliminierung nach Prüfung der Empfangsgebietsüberlappung, kann in gleich vorteilhafter Weise auch bei der eingangs beschriebenen ersten Verfahrensvariante verwendet werden, bei welcher der Vergleichssender durch Sendersuchlauf gefunden und eingestellt wird.

Den vorstehend beschriebenen beiden Verfahrensvarianten ist gemeinsam, daß aus den im Hauptspeicher 16 abgespeicherten Informationen über Sendefrequenz, Senderstandort, Standortkoordinaten und Senderreichweite aller im möglichen Aktionsradius des Rundfungeräts befindlichen Sender alle diejenigen Standorte von Sendern ausgesucht werden, deren Sendefrequenz mit der Empfangsfrequenz eines zu identifizierenden Senders übereinstimmen. Für einen am Ort des Rundfunkgerätes empfangbaren frei wählbaren Vergleichssender werden aus den abgespeicherten Informationen alle zu dem Vergleichssender frequenzgleichen Sender bestimmt und aus den Standortkoordinaten und Senderreichweiten des Vergleichssenders und der frequenzgleichen Sender deren Empfangsgebiete bestimmt und mit den Empfangsgebieten der ausgesuchten Senderstandorte verglichen. Diejenigen der ausgesuchten und im Zwischenspeicher 17 gespeicherten Senderstandorte werden eliminiert, deren Empfangsgebiet sich mit keinem der Empfangsgebiete des Vergleichssenders und der damit frequenzgleichen Sender überlappt. Verbleiben im Zwischenspeicher 17 nach Elimination noch mehrere Senderstandorte, so werden die vorstehenden Verfahrensschritte des Auswählens eines nächsten empfangbaren Vergleichssenders, des Bestimmens der damit frequenzgleichen Sender, des Prüfens auf Überlappen derer Empfangsgebiete mit den Empfangsgebieten der im Zwischenspeicher 17 verbliebenen Senderstandorte und des Eliminierens von Senderstandorten bei Nichtüberlappung solange wiederholt, bis nur ein einziger Senderstandort im Zwischenspeicher 17 verbleibt, der zusammen mit der Empfangsfrequenz den Rundfunksender eindeutig bestimmt. Die beiden Verfahrensvarianten unterscheiden sich lediglich in der Auswahl des oder der erforderlichen Vergleichssender. Während in der ersten Verfahrensvariante der nächstfolgende starke empfangbare Vergleichssender per Suchlauf bestimmt wird, wird in der zweiten Verfahrensvariante der Vergleichssender nach dem Kriterium der geringsten Mehrdeutigkeit und/oder des möglichst großen Reichweitenüberschusses ausgewählt, eingestellt und auf Empfangbarkeit geprüft.

Die Erfindung ist nicht auf die vorstehend beschriebenen Ausführungsbeispiele eines Verfahrens zur Identifikation eines Rundfunksenders beschränkt. So kann der identifizierte Sender nicht nur optisch oder akustisch angezeigt werden, sondern auch zur Steuerung verschiedener Informationen und Vorgänge benutzt werden. Wenn man noch im Empfangsteil die Feldstärke des unter der Empfangsfrequenz empfangenen und mittels des Verfahrens identifizierten Senders mißt, so kann für den Autofahrer eine ungefähre Information über seinen momentanen Standort abgeleitet werden. Aus dem identifizierten Senderstandort und dessen Standortkoordinaten und der Größe der Feldstärke des empfangenen Senders am Empfangsort kann in etwa die Entfernung des Rundfunkempfängers zum Senderstandort angegeben werden. Dem Autofahrer stehen damit zusätzlich Informationen über seinen Standort zur Verfügung.

Der identifizierte Sender kann darüber hinaus zur Auswahl der im Tastenfeld 14 angezeigten, am momentanen Standort des Rundfunkempfängers empfangbaren Sender verwendet werden. Da

## EP 0 150 297 B1

üblicherweise am momentanen Standort des Kraftfahrzeugs nur eine beschränkte Auswahl von Sendern empfangbar sind, kann das Tastenfeld z.B. auf eine Anzahl von sechs Tasten beschränkt werden, die je nach identifizierten Standort des Fahrzeugs bzw. Rundfunkempfängers mit einer entsprechenden optisch auswechselbaren Beschriftung automatisch belegt werden. Weiterhin kann auch unter allen Sendern mit gleichem Programm (z.B. NDR 1), derjenige Sender eingestellt werden, der die beste Empfangsqualität hat.

Es ist selbstverständlich nicht erforderlich, daß im Zwischenspeicher 17 die Senderstandorte mit ihren Standortkoordinaten und Senderreichweiten unmittelbar abgelegt werden, wie dies in Fig. 2 beschrieben ist. Es genügt das Ablegen einer Adresse des Hauptspeichers 16, unter welcher der jeweilige Senderstandort mit Senderreichweite und Standortkoordinaten im Hauptspeicher 16 auffindbar ist. Der Hauptspeicher 16 selbst kann auch als EAROM oder Kassette ausgebildet sein, so daß der Speicherinhalt jederzeit geändert oder ergänzt und damit an sich ergebenden Änderungen angepaßt werden kann.

**Patentansprüche**

1. Verfahren zur Identifikation von mit einem Rundfunkgerät, insbesondere Autoradio, empfangenen Rundfunksendern unter Zuhilfenahme der zugehörigen Empfangsfrequenz, dadurch gekennzeichnet, daß aus abgespeicherten Informationen über Sendefrequenz, Senderstandort mit Standortkoordinaten und Senderreichweite aller im möglichen Aktionsradius des Rundfunkgeräts befindlichen Sender alle diejenigen Standorte von Sendern ausgesucht werden, deren Sendefrequenz mit der Empfangsfrequenz übereinstimmen, daß für einen am Ort des Rundfunkgeräts empfangbaren frei wählbaren Vergleichssender aus den abgespeicherten Informationen alle zu dem Vergleichssender frequenzgleichen Sender bestimmt werden, daß aus den Standortkoordinaten und Senderreichweiten des Vergleichssenders und der frequenzgleichen Sender deren Empfangsgebiete bestimmt und mit den aus den ausgesuchten Standortkoordinaten und den dazugehörigen Senderreichweiten bestimmten Empfangsgebieten der ausgesuchten Senderstandorte verglichen werden, wobie dieser Vergleich aus einem Vergleich der aus den Standortkoordinaten gewonnenen Entfernung der Sender und deren Reichweite beruht, daß diejenigen der ausgesuchten Senderstandorte eliminiert werden, deren Empfangsgebiet sich mit keinem der Empfangsgebiete des Vergleichssenders und der frequenzgleichen Sender überlappen und daß bei Verbleib von mehreren Senderstandorten nach Elimination die Verfahrensschritte des Auswählens eines nächsten empfangbaren Vergleichssenders, des Bestimmens der damit frequenzgleichen Sender, des Prüfens auf Überlappen mit den Empfangsgebieten der verbliebenen Senderstandorte und des Eliminierens von Senderstandorten bei Nichtüberlappung solange wiederholt werden, bis nur ein einziger Senderstandort verbleibt, der zusammen mit der Empfangsfrequenz den Rundfunksender eindeutig bestimmt.

2. Verfahren nach Anspruch 1, dadurch gekennzeichnet, daß als Vergleichssender aus den abgespeicherten Informationen ein Senderstandort ausgewählt wird, dessen Empfangsgebiet sich mit dem Empfangsgebiet eines der ausgesuchten Senderstandorte maximal überlappt und/oder mit der geringsten Zahl von ausgesuchten Senderstandorten eine Empfangsgebietsüberlappung zeigt, und daß die Empfangbarkeit des Vergleichssenders durch Einstellen einer der dem Senderstandort zugehörigen Sendefrequenzen als Empfangsfrequenz im Rundfunkgerät geprüft wird.

3. Verfahren nach Anspruch 2, dadurch gekennzeichnet, daß zur Auswahl des Vergleichssenders derjenige der ausgesuchten Senderstandorte herangezogen wrid, dem der zuletzt empfangene und identifizierte Sender zugehörig ist.

4. Verfahren nach einem der Ansprüche 1—3, dadurch gekennzeichnet, daß die Empfangbarkeit weiterer Vergleichssender und der mit den Vergleichssendern frequenzgleichen Sender nur geprüft wird, wenn die Prüfung der Empfangsgebietsüberlappung zu einer Verringerung der Zahl der Überlappungen und damit der ausgesuchten Senderstandorte führt.

5. Verfahren nach einem der Ansprüche 1—4, dadurch gekennzeichnet, daß die Überlappung der Empfangsgebiete dann festgestellt wird, wenn die Summe der Reichweiten der beiden zu vergleichenden Sender größer ist als die Entfernung zwischen ihren Senderstandorten.

6. Verfahren nach einem der Ansprüche 1—4, dadurch gekennzeichnet, daß die Empfangsfeldstärke des zu identifizierenden Senders und der Vergleichssender gemessen wird, daß für jeden ausgesuchten Senderstandort und die Standorte von Vergleichssendern und damit frequenzgleichen Sendern aus der jeweils gemessenen Empfangsfeldstärke und der Senderreichweite der Sender eine reduzierte, etwa der Entfernung zum Senderstandort entsprechende fiktive Senderreichweite bestimmt wird und daß die Überlappung der Empfangsgebiete dann festgestellt wird, wenn die Summe der fiktiven Senderreichweiten der beiden jeweils zu vergleichenden Sender größer ist als die Entfernung zwischen ihren Senderstandorten.

7. Rundfunkgerät, insbesondere Autoradio, zur Durchführung des Verfahrens nach Anspruch 1, mit einer Sendereinstellautomatik (13) und einem vorzugsweise als Lesespeicher ausgebildeten Hauptspeicher (16), in welchem alle im möglichen Aktionsradius des Rundfunkgeräts empfangbaren Sender mit ihren Sendefrequenzen, Senderstandorten und abgestrahlten Programmen abgespeichert sind, dadurch gekennzeichnet, daß der Hauptspeicher (16) zusätzlich die Standortkoordinaten der Senderstandorte und deren Senderreichweiten abgespeichert enthält und daß vorgesehen sind: ein Zwischenspeicher (17) zum Ablegen von Informationen bezüglich Standortkoordinaten und Senderreichweiten ausgewählter

10

Senderstandorte, die jeweils einen Sender enthalten, dessen Sendefrequenz gleich der Empfangsfrequenz des zu identifizierenden Senders ist, eine Recheneinheit (18), welche einerseits aus Standortkoordinaten zweier Senderstandorte deren Entfernung voneinander berechnet und andererseits die Senderreichweiten zweier jeweils einem der Standorte zugehörigen Sender addiert, eine an die Recheneinheit (18) angeschlossene Vergleichseinheit (19), welche die beiden von der Recheneinheit (18) getrennt ausgegebenen Rechenergebnisse miteinander vergleicht und ein Ausgangssignal ausgibt, wenn die Summe der Reichweiten größer ist als die Entfernung und eine mit der Sendereinstellautomatik (13) dem Haupt- und Zwischenspeicher (16, 17) und der Rechen- und Vergleichseinheit (18, 19) verbundene Steuerschaltung (15), die einerseits das Auslesen aus dem Hauptspeicher (16) und das Einschreiben und das Auslesen aus dem Zwischenspeicher (17) und andererseits das Löschen und Prüfen des Speicherinhalts des Zwischenspeichers (17) sowie die Sendereinstellautomatik (13) steuert, daß diejenigen der ausgesuchten, im Zwischenspeicher (17) abgelegten Senderstandorte eliminiert werden, deren Empfangsgebiet sich mit keinem der Empfangsgebiete eines Vergleichssenders und der frequenzgleichen Sender überlappen und daß bei Verbleib von mehreren Senderstandorten im Zwischenspeicher (17) nach Elimination die von der Steuerlogik (15) eingeleiteten Verfahrensschritte des Auswählens eines nächsten empfangbaren Vergleichssenders, des Bestimmens der damit frequenzgleichen Sender, des Prüfens mittels der Rechen- und Vergleichseinheit (18, 19) auf Überlappen mit den Empfangsgebieten der verbliebenen Senderstandorte und des Eliminierens von Senderstandorten im Zwischenspeicher (17) bei Nichtüberlappung solange wiederholt wird, bis nur ein einziger Senderstandort verbleibt, der zusammen mit der Empfangsfrequenz den Rundfunksender eindeutig bestimmt.

8. Rundfunkgerät nach Anspruch 7, dadurch gekennzeichnet, daß die Steuerschaltung (15) derart ausgebildet ist, daß aus dem Hauptspeicher (16) alle Senderstandorte, die jeweils einen Sender enthalten, dessen Sendefrequenz gleich der Empfangsfrequenz des zur Identifizierung eingestellten Senders ist, mit Standortkoordinaten und Senderreichweiten ausgelesen und in den Zwischenspeicher (17) eingeschrieben werden, daß die Sendereinstellautomatik (13) gestartet wird, die als Suchlaufautomatik den nächsten, vorzugsweise mit großer Feldstärke empfangbaren Sender als Vergleichssender einstellt, daß im Hauptspeicher (16) nacheinander die Senderstandorte, die jeweils einen mit dem Vergleichssender frequenzgleichen Sender enthalten, aufgerufen und deren Standortkoordinaten und Senderreichweiten der Recheneinheit (18) zugeführt werden, daß zu jedem aufgerufenen Senderstandort nacheinander der Recheneinheit (18) die Standortkoordinaten und Senderreichweiten der im Zwischenspeicher (17) abgespeicherten Senderstandorte zugeführt werden, daß mit jedem Ausgangssignal der Vergleichsschaltung (19) der zugehörige Senderstandort im Zwischenspeicher (17) markiert wird, daß nach Vergleich aller aus dem Hauptspeicher (16) ausgelesenen Senderstandorte mit allen im Zwischenspeicher (17) abgelegten Senderstandorten bei Vorhandensein mindestens eines markierten Senderstandortes die nichtmarkierten Senderstandorte im Zwischenspeicher (17) gelöscht werden, und daß danach bei Verbleib von mehr als einem Senderstandort im Zwischenspeicher (17) die Sendereinstellautomatik (13) erneut gestartet wird.

9. Rundfunkgerät nach Anspruch 7, dadurch gekennzeichnet, daß die Steuerschaltung (15) derart ausgebildet ist, daß aus dem Hauptspeicher (16) alle Senderstandorte, die jeweils einen Sender enthalten, dessen Sendefrequenz gleich der Empfangsfrequenz des zu identifizierenden Senders ist, mit Standortkoordinaten und Senderreichweiten ausgelesen und in den Zwischenspeicher (17) eingeschrieben werden, daß der Recheneinheit (18) einerseits Standortkoordinaten und die Senderreichweite eines im Zwischenspeicher (17) abgelegten Senderstandortes, vorzugsweise des dem zuvor empfangenen Sender zugehörigen Senderstandortes, und andererseits solange die Standortkoordinaten und Senderreichweite der im Hauptspeicher (16) abgelegten Senderstandorte, vorzugsweise in der abgelegten Reihenfolge der Senderstandorte, nacheinander zugeführt werden, bis an der Vergleichseinheit (19) ein Ausgangssignal auftritt, daß mit Auftreten des Ausgangssignals dem Hauptspeicher (16) eine Sendefrequenz des Senderstandortes entnommen, mittels der Sendereinstellautomatik (13) eingestellt und deren Empfangsbarkeit geprüft wird, daß bei Empfang der Recheneinheit (18) einerseits die Standortkoordinaten und die Senderreichweiten der der empfangbaren Sendefrequenz zugehörigen Senderstandorte und andererseits sukzessive die Standortkoordinaten und die Senderreichweiten der im Zwischenspeicher (17) abgespeicherten Senderstandorte zugeführt und bei Ausbleiben eines Ausgangssignals an der Vergleichseinheit (19) die jeweiligen Senderstandorte im Zwischenspeicher (17) gelöscht werden und daß mit weiteren Sendefrequenzen des aus dem Hauptspeicher (16) entnommenen Senderstandortes die vorstehenden Steuerschritte solange wiederholt werden, bis im Zwischenspeicher (17) ein einziger Senderstandort verbleibt.

10. Rundfunkgerät nach Anspruch 9, dadurch gekennzeichnet, daß zum Auffinden des Senderstandortes des einzustellenden Vergleichssenders an den Ausgängen der Recheneinheit (18) eine Subtrahierstufe (21) angeschlossen ist, welche die Differenz aus der Summe der Senderreichweiten und der Entfernung der Senderstandorte bildet und daß an der Subtrahierstufe (21) ein Maximumsucher (22) angeschlossen ist, der den aus dem Hauptspeicher (16) der Recheneinheit (18) zugeführten Senderstandort mit der größten Differenz bestimmt.

# EP 0 150 297 B1

## Revendications

1. Procédé d'identification d'émetteurs-radio reçus à l'aide d'un appareil-radio notamment d'un auto-radio à l'aide de la fréquence de réception correspondante, procédé caractérisé en ce que parmi les informations mises en mémoire relatives à la fréquence d'émission, à l'emplacement de l'émetteur avec les coordonnées de l'emplacement et la portée de tous les émetteurs possibles qui se trouvent dans le rayon d'action de l'appareil-radio, on sélectionne tous les emplacements des émetteurs dont la fréquence d'émission correspond à la fréquence de réception, et pour un émetteur de comparaison choisi librement, reçu à l'emplacement de l'appariel-radio, on détermine parmi les informations inscrites en mémoire, tous les émetteurs de même fréquence que celle de l'émetteur de comparaison, à partir des coordonnées de l'emplacement et de la portée de l'émetteur de comparaison et des émetteurs de même fréquence, on détermine leur zone de réception et on les compare avec les zones de réception des emplacements d'émetteurs recherchés, en utilisant les coordonnées de l'emplacement et les portées correspondantes, cette comparaison reposant sur la comparaison de l'éloignement des émetteurs et de leurs portées, obtenue à partir des coordonnées de l'emplacement, en ce qu'on élimine les emplacements d'émetteurs recherchés, dont la zone de réception ne se recouvre avec aucune des zones de réception de l'émetteur de comparaison ou de l'émetteur de même fréquence et s'il reste plusieurs emplacements d'émetteurs après cette élimination, on répète les étapes de procédé consistant à sélectionner un émetteur de comparaison susceptible d'être reçu à la suite, on détermine les émetteurs de même fréquence, on vérifie le recouvrement avec les zones de réception des emplacements d'émetteurs qui restent et on élimine les emplacements des émetteurs en cas de non recouvrement, cette répétition se faisant jusqu'à ce qu'il ne subsiste qu'un seul emplacement d'émetteurs qui, avec la fréquence de réception, définit sans équivoque l'émetteur-radio.

2. Procédé selon la revendication 1, caractérisé en ce que comme émetteur de comparaison, on choisit dans les informations inscrites en mémoire, un emplacement d'émetteurs dont la zone de réception se recouvre au maximum avec la zone de réception de l'un des emplacements d'émetteurs recherchés et/ou présente un recouvrement des zones de réception avec le nombre le plus faible d'emplacements d'émetteurs recherchés, et en ce qu'on vérifie la réception de l'émetteur de comparaison en réglant comme fréquence de réception l'une des fréquences d'émission de cet emplacement d'émetteurs dans l'appareil-radio.

3. Procédé selon la revendication 2, caractérisé en ce que pour choisir l'émetteur de comparaison, on utilise celui des emplacements d'émetteurs recherchés auxquels appartient l'émetteur identifié et reçu en dernier lieu.

4. Procédé selon l'une des revendications 1 à 3, caractérisé en ce qu'on vérifie la réception d'autres émetteurs de comparaison et des émetteurs de même fréquence que celle de l'émetteur de comparaison seulement si la vérification du recouvrement de la zone de réception aboutit à une réduction du nombre des recouvrements et ainsi du nombre des emplacements d'émetteurs, sélectionnés.

5. Procédé selon l'une des revendications 1—4, caractérisé en ce qu'on constate le recouvrement des zones de réception si la somme des portées des deux émetteurs à comparer est supérieure à l'éloignement de l'emplacement des émetteurs.

6. Procédé selon l'une des revendications 1—4, caractérisé en ce qu'on mesure l'intensité du champ reçu de l'émetteur à identifier et de l'émetteur de comparaison, et pour chaque emplacement d'émetteurs trouvé et les emplacements des émetteurs de comparaison et ainsi les émetteurs de même fréquence, on détermine à partir de l'intensité du champ respectivement mesuré et de la portée des émetteurs, une portée réduite correspondant sensiblement à l'éloignement par rapport à l'emplacement de l'émetteur et on détermine le recouvrement des zones de réception si la somme des portées fictives des deux émetteurs comparés est supérieure à l'éloignement de leurs emplacements.

7. Appareil-radio notamment auto-radio pour la mise en oeuvre du procédé selon la revendication 1 comportant un circuit automatique de réglage (13) et une mémoire principale (16) de préférence une mémoire morte qui contient tous les émetteurs susceptibles d'être reçus dans le rayon d'action de l'appareil-radio, ainsi que les fréquences d'émission, les emplacements et les programmes émis par ces émetteurs, appareil caractérisé en ce que la mémoire principale (16) contient en outre les coordonnées des emplacements des émetteurs et leurs portées et en ce qu'en outre il est prévu une mémoire-tampon (17) pour recevoir les informations concernant les coordonnées de l'emplacement et les portées des emplacements d'émetteurs choisis, qui correspondant chaque fois à un émetteur dont la fréquence d'émission est égale à la fréquence de réception de l'émetteur à identifier, une unité de calcul (18) qui calcule d'une part l'éloignement de deux emplacements d'émetteur à partir de leurs coordonnées et qui additionne d'autre part les portées des emplacements respectifs de deux émetteurs, un comparateur (19) relié à l'unité de calcul (18) qui compare les deux résultats de calcul fournis séparément par l'unité de calcul et émet un signal de sortie si la somme des portées est supérieure à l'éloignement ainsi qu'un circuit de commande (15) relié au circuit de réglage automatique (13) à la mémoire principale et à la mémoire intermédiaire (16, 17) et à l'unité de calcul (18) et au comparateur (19), circuit de commande qui commande d'une part la lecture dans la mémoire principale (16) et l'inscription et la lecture dans la mémoire-tampon (17) et d'autre part l'effacement et le contrôle du contenu de la mémoire-tampon (17) ainsi que du circuit de réglage automatique d'émetteur (13) pour éliminer les emplacements de mémoire inscrits dans la

12

mémoire-tampon (17) dont la zone de réception ne se recouvre avec aucune zone de réception d'un émetteur de comparaison et des émetteurs de même fréquence et en ce que lorsqu'il reste plusieurs emplacements d'émetteurs dans la mémoire-tampon (17) après cette élimination, on répète les opérations commandées par la logique de commande (15) pour sélectionner l'émetteur de comparaison suivant, susceptible d'être reçu, on détermine l'émetteur de même fréquence, on contrôle à l'aide de l'unité de calcul (18) et du comparateur (19) pour le recouvrement avec les zones de réception des emplacements d'émetteurs restants et on élimine les emplacements d'émetteurs de la mémoire-tampon (17) en cas de non recouvrement, cette opération étant répétée jusqu'à ce qu'il ne subsiste qu'un seul emplacement d'émetteur qui définit avec la fréquence de réception, sans équivoque l'émetteur-radio.

8. Appareil-radio selon la revendication 7, caractérisé en ce que le circuit de commande (15) est conçu pour qu'à partir de la mémoire principale (16) on puisse inscrire tous les emplacements d'émetteurs qui correspondent chaque fois à un émetteur dont la fréquence est égale à la fréquence de réception de l'émetteur réglée pour l'identification, avec les coordonnées de l'emplacement et les portées dans la mémoire-tampon (17), on démarre le circuit automatique de réglage d'émetteur (13) qui recherche par une recherche automatique, l'émetteur suivant, susceptible d'être reçu, offrant l'intensité de champ la plus forte pour constituer l'émetteur de comparaison, on appelle dans la mémoire principale (16), successivement les emplacements d'émetteurs qui ont la même fréquence que celle de l'émetteur de comparaison et on transmet leurs coordonnées et leurs portées à l'unité de calcul (18), en ce que pour chaque emplacement d'émetteur appelé, successivement l'unité de calcul (18) reçoi les coordonnées de l'emplacement et la portée des emplacements inscrits dans la mémoire-tampon (17), et pour chaque signal de sortie du circuit de comparaison (19), l'emplacement correspondant de l'émetteur est repéré dans la mémoire-tampon (17), en ce qu'après comparaison de tous les emplacements d'émetteurs lus dans la mémoire principale (16) et de tous les emplacements d'émetteurs inscrits dans la mémoire-tampon (17), lorsqu'existe au moins un emplacement d'émetteur, repéré, on efface les emplacements d'émetteurs non repérés dans la mémoire-tampon (17) et s'il reste plus d'un emplacement d'émetteurs dans la mémoire-tampon (17), on démarre de nouveau le circuit de réglage automatique d'émetteur (13).

9. Appareil-radio selon la revendication 7, caractérisé en ce que le circuit de commande (15) est réalisé pour prendre dans la mémoire principale (16) tous les emplacements d'émetteurs qui correspondent chaque fois à un émetteur dont la fréquence d'émission est égale à la fréquence de réception de l'émetteur à identifier, avec les coordonnées de l'emplacement et la portée, pour les inscrire dans la mémoire-tampon (17), l'unité de calcul (18) recevant successivement d'une part les coordonnées de l'emplacement et la portée d'un emplacement d'émetteurs inscrit dans la mémoire-tampon (17), de préférence l'emplacement de l'émetteur qui a été reçu précédemment et d'autre part, aussi longtemps que les coordonnées d'emplacement et la portée des emplacements d'émetteurs inscrits dans la mémoire principale (16), de préférence dans l'ordre d'inscription des emplacements de mémoire, jusqu'à ce que le comparateur (19) émette un signal de sortie, en ce qu'à l'arrivée de ce signal de sortie, on prend une fréquence d'émission de l'emplacement de l'émetteur dans la mémoire principale (16), on règle à l'aide d'un circuit automatique de réglage d'émetteur (13) et on vérifie la réception et en ce qu'à la réception, l'unité de calcul (18) reçoi d'une part les coordonnées d'emplacement et les portées des emplacements d'émetteurs associées à la fréquence d'émission susceptibles d'être reçue et d'autre part successivement les coordonnées d'emplacement et les portée d'émetteur des emplacements d'émetteurs inscrits dans la mémoire-tampon (17) et en l'absence d'un signal de sortie du comparateur (19), les emplacements d'émetteurs respectifs sont effacés dans la mémoire-tampon (17) et pour les autres fréquences d'émission de l'emplacement des émetteurs pris dans la mémoire principale (16) on répète les opérations décrites ci-dessus jusqu'à ce qu'il ne subsiste qu'un seul emplacement d'émetteurs dans la mémoire-tampon (17).

10. Appareil-radio selon la revendication 9, caractérisé en ce que pour trouver l'emplacement des émetteurs de l'émetteur de comparaison à régler, on a branché un étage de soustraction (21) sur les sorties de l'unité de calcul (18), soustracteur qui forme la différence de la somme des portées et de l'éloignement des emplacements des émetteurs et un circuit de recherche de maximum (22) est relié à l'étage de soustraction (21), circuit qui détermine l'emplacement de l'émetteur pris par l'unité de calcul (18) dans la mémoire principale (16) et présentant la différence la plus grande.

**Claims**

1. Method for identifying broadcast transmitters which are received by means of a broadcast set, particularly a car radio, with the assistance of the associated receiving frequency, characterized in that from stored information items on transmitting frequency, transmitter site with site coordinates and transmitter range of all transmitters located within the possible range of the broadcast set, all those sites of transmitters of which the transmitting frequency corresponds to the receiving frequency are selected, in that for a freely selectable reference transmitter which can be received at the location of the broadcast set, all transmitters with the same frequency as the reference transmitter are determined from the stored information items, that from the site coordinates and the transmitter ranges of the reference transmitter and of the transmitters with the same frequency, their service areas are determined and compared with the service areas of the selected transmitter sites determined from the selected site coordinates and the associated transmitter ranges, this comparison being based on a comparison of the distance of the

13

transmitters, obtained from the site coordinates, and their range, that those of the selected transmitter sites of which the service area (sic) do not overlap with any of the service areas of the reference transmitter or of the transmitters with the same frequency are eliminated and that, if after elimination several transmitter sites remain, the method steps of selecting a next receivable reference transmitter, of determining the transmitters having the same frequencies as this transmitter, of checking for overlap with the service areas of the remaining transmitter sites and of eliminating transmitter sites in the case of non-overlap are repeated until only a single transmitter site remains which, together with the receiving frequency, unambiguously determines the broadcast transmitter.

2. Method according to Claim 1, characterized in that, as reference transmitter, a transmitter site, of which the service area has a maximum overlap with the service area of one of the selected transmitter sites and/or shows a service area overlap with the smallest number of selected transmitter sites is selected from the stored information items, and that the receivability of the reference transmitter is checked by setting one of the transmitting frequencies associated with the transmiter site as receiving frequency in the broadcast set.

3. Method according to Claim 2, characterized in that, of the selected transmitter sites, the one associated with the transmitter last received and identified is used for selecting the reference transmitter.

4. Method according to one of Claims 1—3, characterized in that the receivability of further reference transmitters and of the transmitters having the same frequency as the reference transmitters is only checked if the checking of the service area overlap leads to a reduction in the number of overlaps and thus of the selected transmitter sites.

5. Method according to one of Claims 1—4, characterized in that the overlap of the service areas is determined when the sum of the ranges of the two transmitters to be compared is greater than the distance betwen their transmitter sites.

6. Method according to one of Claims 1—4, characterized in that the received field strength of the transmitter to be identified and of the reference transmitters is measured, that for each selected transmitter site and the sites of reference transmitters and thus transmitters of the same frequency, a reduced fictitious transmitter range, which approximately corresponds to the distance from the transmitter site, is determined from the received field strength measured in each case and from the transmitter range of the transmitters, and that the overlap of the service areas is determined when the sum of the fictitious transmitter ranges of the two transmitters to be compared in each case is greater than the distance between their transmitter sites.

7. Broadcast set, particularly car radio, for carrying out the method according to Claim 1, comprising an automatic transmitter tuning system (13) and a main store (16) which is preferably constructed as read-only memory and in which all transmitters, which can be received within the possible range of the broadcast set are stored with their transmitting frequencies, transmitter sites and radiated programmes, characterized in that the main store (16) additionally contains stored the site coordinates of the transmitter sites and their transmitter ranges and that the following are provided: a buffer store (17) for depositing information items with respect to site coordinates and transmitter ranges of selected transmitter sites, which in each case contains a transmitter, the transmitting frequency of which is equal to the receiving frequency of the transmitter to be identified, a computing unit (18) which, on the one hand, calculates from site coordinates of two transmitter sites their distance from one another and, on the other hand, adds the transmitter ranges of two transmitters in each case belonging to one of the sites, a comparison unit (19) which is connected to the computing unit (18) and which compares with one another the two computing results output separately by the computing unit (18) and outputs an output signal when the sum of the ranges is greater than the distance and a control circuit (15) which is connected to the automatic transmitter tuning system (13), the main and buffer store (16, 17) and the computing and comparison unit (18, 19), which control circuit, on the one hand, controls the read-out from the main store (16) and the writing-in and the read-out from the buffer store (17) and, on the other hand, the clearing and checking of the memory content of the buffer store (17) and the automatic transmitter tuning system (13), in that those of the selected transmitter sites, stored in the buffer store (17), of which the service area (sic) do not overlap with any of the service areas of a reference transmitter and of the transmitters with the same frequency are eliminated and that of several transmitter sites remaining in the buffer store (17) after elimination, the method steps initiated by the control logic (15), of selecting a next receivable reference transmitter, of determining the transmitters having the same frequency as the former, of checking for overlap with the service areas of the remaining transmitter sites by means of the computing and comparison unit (18, 19) and of eliminating transmitter sites in the buffer store (17) in the case of non-overlap, is (sic) repeated until only a single transmitter site remains, which, together with the receiving frequency, unambiguously determines the broadcast transmitter.

8. Broadcast set according to Claim 7, characterized in that the control circuit (15) is constructed in such a manner that all transmitter sites which in each case contain a transmitter of which the transmitting frequency is equal to the receiving frequency of the transmitter set for identification are read out with site coordinates and transmitter ranges from the main store (16) and are entered into the buffer store (17), that the automatic transmitter tuning system (13) is started which, as automatic station finding system, sets as reference transmitter the next transmitter which is preferably receivable at high field strength, that in the main store (16) the transmitter sites which in each case contain a transmitter having the same frequency as

14

the reference transmitter are successively called up and their site coordinates and transmitter ranges are supplied to the computing unit (18), that for each transmitter site called up, the site coordinates and transmitter ranges of the transmitter sites stored in the buffer store (17) are successively supplied to the computing unit (18), that with each output signal of the comparison circuit (19), the associated transmitter site is marked in the buffer store (17), that after comparing all transmitter sites read out from the main store (16) with all transmitter sites stored in the buffer store (17), the transmitter sites not marked are cleared in the buffer store (17) if at least one marked transmitter site exists, and that the automatic transmitter tuning system (13) is started again thereafter if more than one transmitter site remains in the buffer store (17).

9. Broadcast set according to Claim 7, characterized in that the control circuit (15) is constructed in such a manner that all transmitter sites which in each case contain a transmitter of which the transmitting frequency is equal to the receiving frequency of the transmitter to be identified are read out from the main store (16) with site coordinates and transmitter ranges and are entered in the buffer store (17), that the computing unit (18) is successively supplied, on the one hand, with site coordinates and the transmitter range of a transmitter site stored in the buffer store (17), preferably of the transmitter site associated with the previously received transmitter, and, on the other hand, with the site coordinates and transmitter range of the transmitter sites stored in the main store (16), preferably in the order in which the transmitter sites have been stored, until an output signal occurs at the comparison unit (19), that on occurrence of the output signal, a transmitting frequency of the transmitter site is taken from the main store (16), set by means of the automatic transmitter tuning system (13) and its receivability is checked, that on reception, the computing unit (18) is supplied, on the one hand, with the site coordinates and the transmitter ranges of the transmitter sites associated with the receivable transmitting frequency and, on the other hand, successively with the site coordinates and the transmitter ranges of the transmitter sites stored in the buffer store (17) and, if there is no output signal at the comparison unit (19), the respective transmitter sites are cleared in the buffer store (17) and that the above control steps are repeated with further transmitting frequencies of the transmitter site taken from the main store (16) until a single transmitter site remains in the buffer store (17).

10. Broadcast set according to Claim 9, characterized in that, for finding the transmitter site of the reference transmitter to be set, the outputs of the computing unit (18) are connected to a subtracting stage (21) which forms the difference between the sum of the transmitter ranges and the distance of the transmitter sites, and that the subtracting stage (21), is connected to a maximum-finding stage (22) which determines the transmitter site, supplied to the computing unit (18) from the main store (16), which has the greatest difference.

FIG. 1

| Senderstandort | Standortkoordinaten | | Sender-reichweite |
|---|---|---|---|
| Bad Reichenhall | 12 E 54 | 47 N 44 | 77 |
| Köln | 6 E 57 | 50 N 57 | 79 |
| Raichberg | 9 E 00 | 48 N 18 | 141 |
| Visselhövede | 9 E 37 | 52 N 59 | 105 |
| Wertheim | 9 E 31 | 49 N 45 | 54 |

FIG. 2

EP 0 150 297 B1

FIG. 3